# EUROPEAN PATENT APPLICATION

(11) **EP 4 719 031 A1**
(43) Date of publication of application: **01.04.2026**
(21) Application number: 25204661.0
(22) Date of filing: 25.09.2025
(51) Int. Cl.: H10W 40/47

(54) **WATER-COOLING PLATE AND METHOD OF FORMING THEREOF**

(30) Priority: 25.09.2024 TW 113210398 U
(71) Applicant: Cooler Master Co., Ltd., Taipei City 114065 (TW)
(72) Inventor: LIU, HSIANG-MING, 114065 Taipei City (TW)
(74) Representative: Grünecker Patent- und Rechtsanwälte PartG mbB

(57) **Abstract**

A water-cooling plate and a method of forming thereof where the water-cooling plate comprises at least one cooling plate body comprising a first heat-conducting square tube and a second heat-conducting square tube. The first heat-conducting square tube has a first flow channel, a fluid inlet, and a first fluid communication port. The fluid inlet and the first fluid communication port are in communication with the first flow channel. The second heat-conducting square tube is connected to the first heat-conducting square tube and has a second flow channel, a second fluid communication port, and a fluid outlet. The fluid outlet and the second fluid communication port are in communication with the second flow channel. The first flow channel is in communication with the second flow channel through the first fluid communication port and the second fluid communication port.

## Description

This application claim priority from Taiwan Patent App. No. 113210398, filed September 25, 2024, the content of which (including all attachments filed therewith) is hereby incorporated by reference in its entirety.

### TECHNICAL FIELD

The present disclosure relates to a water-cooling plate, in particular to a structure, configuration, and formation of a water-cooling plate provided with two heat-conducting square tubes which are connected to each other.

### BACKGROUND OF THE DISCLOSURE

The operation of electronic devices is accompanied by the generation of a large amount of heat. If the heat cannot be effectively removed, it may cause internal electronic components to overheat, leading to problems such as functional failure or system crash. Therefore, the electronic devices are often configured with corresponding cooling systems therein to ensure that components do not operate beyond their default operating temperature range. Especially for high-performance electronic devices, a liquid cooling system such as a water cooling plate is usually employed to provide a better heat dissipation effect.

In general, heat exchange channels within a water-cooling plate are formed by means of Computer Numerical Control (CNC) machining. However, in addition to the high manufacturing cost, the water-cooling plate manufactured by means of CNC machining has a small heat exchange channel volume, which cannot meet the requirements of heat dissipation efficiency. Therefore, how to reduce the manufacturing cost of water-cooling plates and improve the heat dissipation efficiency is one of the problems that R&D personnel should solve.

### SUMMARY OF THE DISCLOSURE

Exemplary embodiments of the present disclosure provide a water-cooling plate and a method of forming a water-cooling plate that may, but are not required to, facilitate reduction in the manufacturing cost of the water-cooling plate and improving the heat dissipation efficiency.

A water-cooling plate provided in an example embodiment of the disclosure comprises at least one cooling plate body. The at least one cooling plate body comprises a first heat-conducting square tube and a second heat-conducting square tube. In an example implementation, the first heat-conducting square tube can have a first flow channel, a fluid inlet, and a first fluid communication port. The fluid inlet and the first fluid communication port can be, for example, in communication with the first flow channel. In an exemplary implementation, the second heat-conducting square tube can be, for example, connected to the first heat-conducting square tube and can have a second flow channel, a second fluid communication port, and a fluid outlet. In an exemplary implementation, the fluid outlet and the second fluid communication port can be in communication with the second flow channel. The first flow channel can be in communication with the second flow channel through the first fluid communication port and the second fluid communication port.

According to the water-cooling plate of the above embodiment, since the water-cooling plate can provided with a first heat-conducting square tube and a second heat-conducting square tube in the shape of a square column, and the first heat-conducting square tube and the second heat-conducting square tube are connected by means of soldering, compared with water-cooling plates manufactured by means of CNC machining, not only is the manufacturing cost may be lower, but the volume of the first flow channel and the second flow channel used for heat exchange can also be increased. In such an example implementation, the heat dissipation efficiency of the water-cooling plate can be improved.

Furthermore, according to example implementation of the disclosed example embodiments, when manufacturers want to produce water-cooling plates of different sizes, they may only need to adjust the width and height of the first heat-conducting square tube and the second heat-conducting square tube. That is to say, in exemplary implementations, the structural design of the water-cooling plate of such example embodiment may be highly flexible.

The above description of the summary of the present disclosure and the following description of the example embodiments are used to illustrate and explain the principles of the present disclosure, and can facilitate a further understanding of the appended claims of the present disclosure.

### BRIEF DESCRIPTION OF THE DRAWINGS

A more complete appreciation of the present disclosure and many of the attendant advantages thereof will be readily obtained as the same becomes better understood by reference to the following detailed description when considered in connection with the accompanying drawings, wherein:
Fig. 1 is a perspective schematic view of a water-cooling plate according to an example embodiment of the present disclosure.
Fig. 2 is an exploded schematic view of the water-cooling plate of Fig. 1.
Fig. 3 is an exploded schematic view of example implementations of a cooling plate body, an elastic snap-fit member, a flow distribution member, and a shielding member of the water-cooling plate of Fig. 1.
Fig. 4 is an exploded schematic view of the example implementations of the cooling plate body, the elastic snap-fit member, the flow distribution member, and the shielding member of the water-cooling plate of Fig. 1 from another viewing angle.
Fig. 5 is a schematic cross-sectional view of the water-cooling plate of Fig. 1.

### DETAILED DESCRIPTION OF EXEMPLARY EMBODIMENTS

Detailed features and advantages of embodiments of the present utility model are described in detail below in embodiments, the content of which is sufficient to allow any person skilled in the art to understand and thereby implement the technical content of embodiments of the present utility model, and any person skilled in the art can readily understand the relevant objectives and advantages of the present utility model on the basis of the content disclosed herein, the claims and the drawings. The embodiments below describe the viewpoints of the present utility model in further detail, but none of these viewpoints limits the scope of the present utility model. Accordingly, those of ordinary skill in the art will recognize that various changes and modifications of the embodiments described herein can be made without departing from the scope and spirit of the described disclosure. Also, descriptions of well-known functions and constructions are omitted for clarity and conciseness.

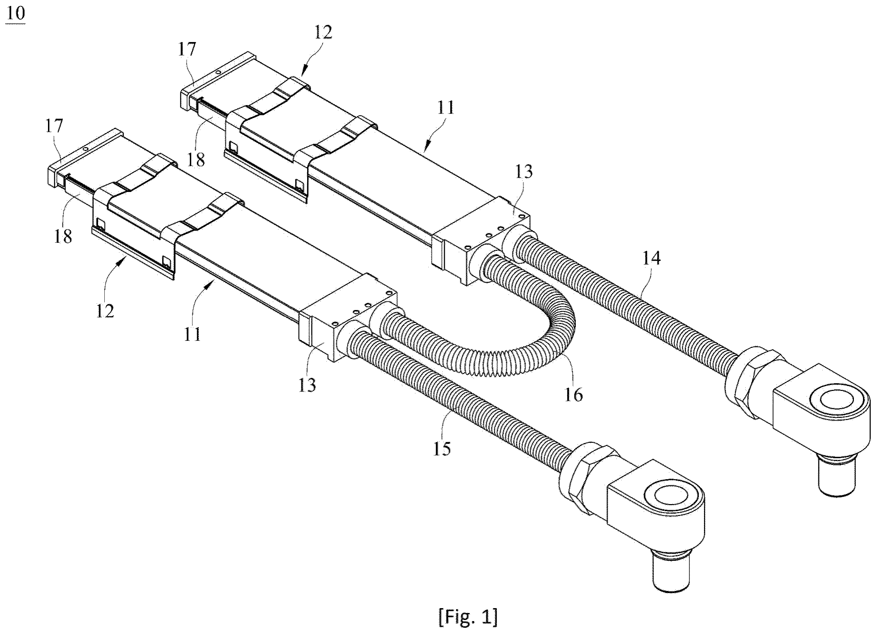

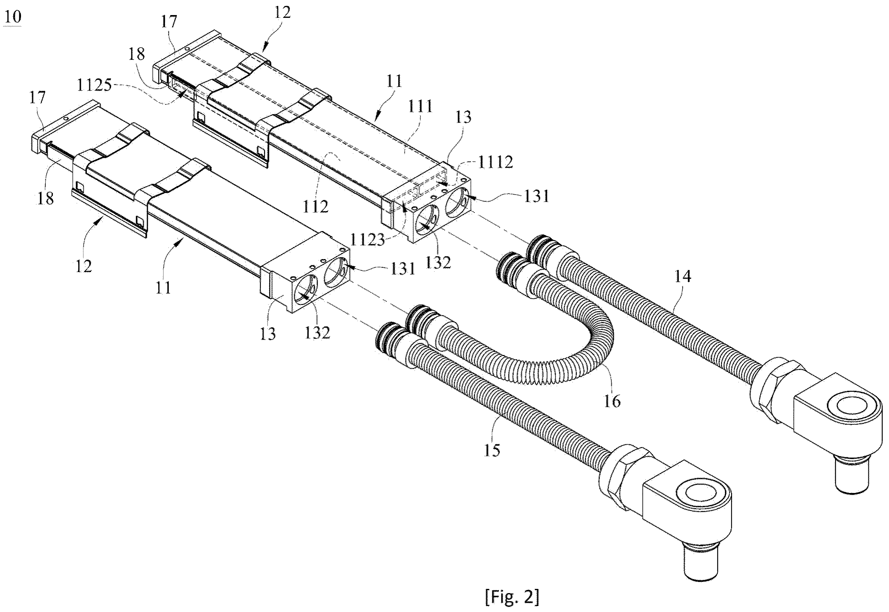

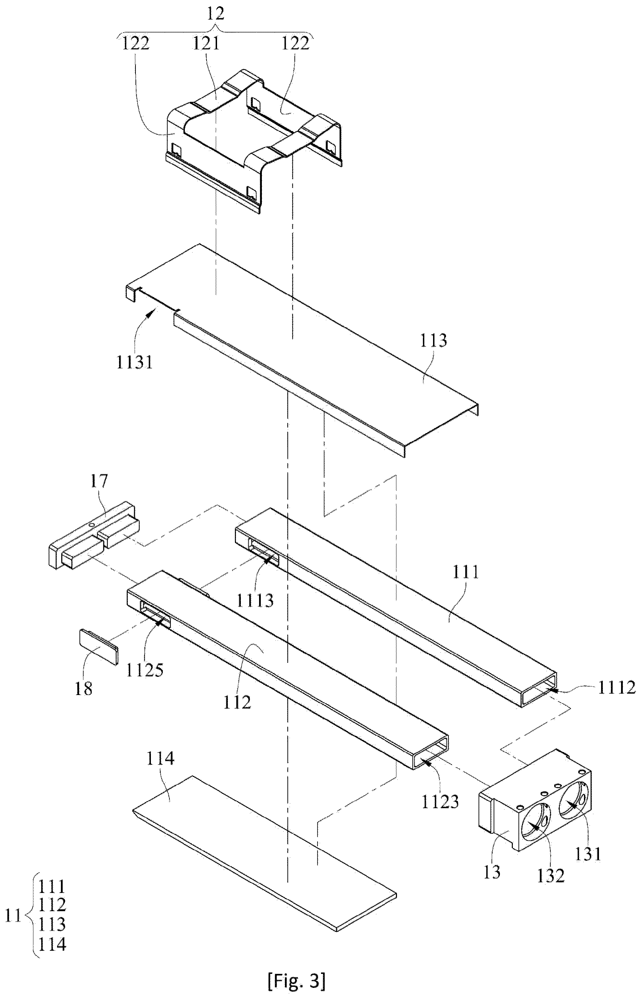

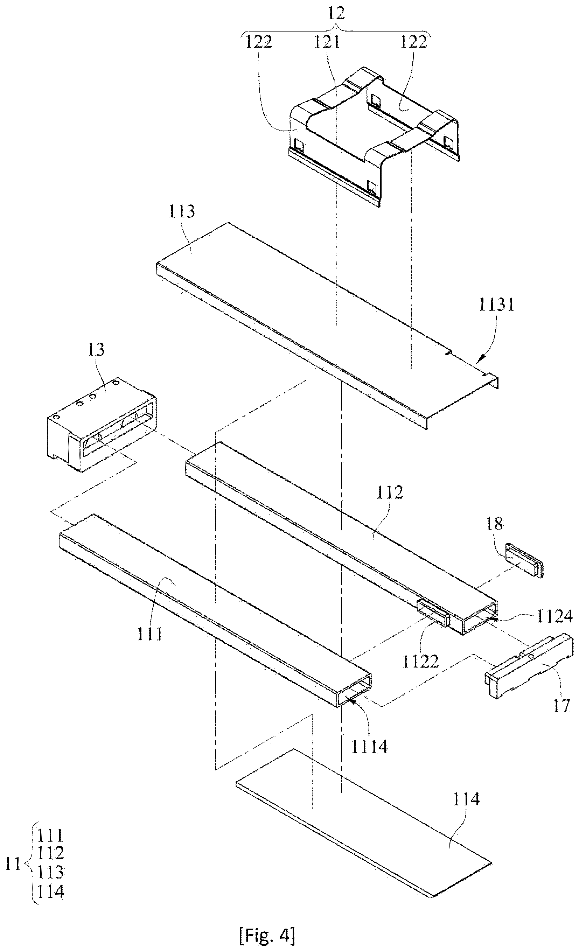

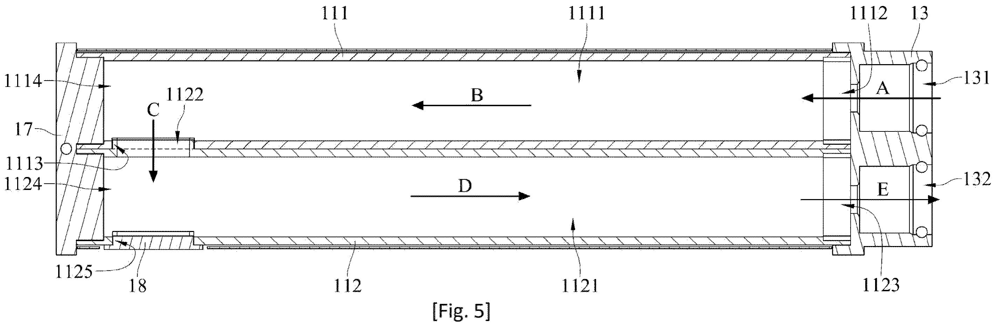

Referring to Figs. 1 to 5: Fig. 1 is a perspective schematic view of a water-cooling plate according to an example embodiment of the present disclosure; Fig. 2 is an exploded schematic view of an example implementation of the water-cooling plate of Fig. 1; Fig. 3 is an exploded schematic view of an example embodiments of a cooling plate body, an elastic snap-fit member, a flow distribution member, and a shielding member of the water-cooling plate of Fig. 1; Fig. 4 is an exploded schematic view of an example embodiments of the cooling plate body, the elastic snap-fit member, the flow distribution member, and the shielding member of the water-cooling plate of Fig. 1 from another viewing angle; and Fig. 5 is a schematic cross-sectional view of the water-cooling plate of Fig. 1.

The water-cooling plate 10 according to an example embodiment can comprise two cooling plate bodies 11, two elastic snap-fit members 12, two flow distribution members 13, a liquid inlet flow tube 14, a liquid outlet flow tube 15, and a connecting flow tube 16. In an example implementation, each cooling plate body 11 comprises a first heat-conducting square tube 111, a second heat-conducting square tube 112, a top plate 113, and a bottom plate 114.

According to example implementation of example embodiments, the first heat-conducting square tube 111 and the second heat-conducting square tube 112 are, for example, copper tubes. For example, the material of the first heat-conducting square tube 111 and the material of the second heat-conducting square tube 112 are, for example, phosphorus-deoxidized copper (TP2). The first heat-conducting square tube 111 and the second heat-conducting square tube 112 are, for example, arranged side by side and thermally coupled to each other. In this way, heat conduction can be carried out between the first heat-conducting square tube 111 and the second heat-conducting square tube 112. The so-called thermal coupling refers to a thermal contact or a connection through other heat-conducting media. The first heat-conducting square tube 111 and the second heat-conducting square tube 112 can be used to contain a coolant (not shown). The coolant is, for example, water or a refrigerant.

According to example implementation of example embodiments, the first heat-conducting square tube 111 can have a first flow channel 1111, a fluid inlet 1112, and a first fluid communication port 1113. The fluid inlet 1112 and the first fluid communication port 1113 can be in communication with the first flow channel 1111. The second heat-conducting square tube 112 can be connected to the first heat-conducting square tube 111. For example, the second heat-conducting square tube 112 can be connected to the first heat-conducting square tube 111, for example and without limitation, by means of hard soldering. The second heat-conducting square tube 112 can have a second flow channel 1121, a second fluid communication port 1122, and a fluid outlet 1123. The fluid outlet 1123 and the second fluid communication port 1122 can be in communication with the second flow channel 1121. The first flow channel 1111 can be in communication with the second flow channel 1121 through the first fluid communication port 1113 and the second fluid communication port 1122.

In an example embodiment, the cross-section of the first flow channel 1111 parallel to the fluid inlet 1112 and the cross-section of the second flow channel 1121 parallel to the fluid outlet 1123 can be, for example, rectangular. In a further example implementation, the first heat-conducting square tube 111 and the second heat-conducting square tube 112 can be at least partially sandwiched between a top plate 113 and a bottom plate 114. The top plate 113 can be made of, for example, cold-rolled steel sheet (SPCC), and the bottom plate 114 can be made of, for example, copper (e.g., Cu1100). Furthermore, the top plate 113 can be connected to the first heat-conducting square tube 111 and the second heat-conducting square tube 112, for example, by means of soft soldering, and the bottom plate 114 can be connected to the first heat-conducting square tube 111 and the second heat-conducting square tube 112, for example, by means of hard soldering.

In yet further example implementations, the two elastic snap-fit members 12 can be disposed on the two top plates 113 to press against the two cooling plate bodies 11, respectively, and can be used to snap onto a plate body (not shown) provided with a heat source (not shown) to thermally couple the two cooling plate bodies 11 to the heat source. For example, each elastic snap-fit member 12 can comprise a pressing portion 121 and two snap-fit portions 122. The two snap-fit portions 122 can be connected to opposite sides of the pressing portion 121. The pressing portion 121 can be configured to press against the top plate 113, for example, to more tightly thermally couple the two cooling plate bodies 11 to the heat source. The two snap-fit portions 122 can be configured to snap onto the plate body to fix the two cooling plate bodies 11. The material of the elastic snap-fit members 12 can be, for example and without limitation, stainless steel (such as, for example, SUS301 1/2H).

In still further example implementations, the flow distribution member 13 can be disposed on one side of the first heat-conducting square tube 111 and the second heat-conducting square tube 112. The material of the flow distribution member 13 can be, for example and without limitation, copper (such as, for example, Cu1100), and the flow distribution member 13 can be connected to the first heat-conducting square tube 111 and the second heat-conducting square tube 112, for example, by means of hard soldering. The flow distribution member 13 can have a flow distribution inlet 131 and a flow distribution outlet 132. The fluid inlet 1112 of one of the two cooling plate bodies 11 can be in communication with a liquid inlet flow tube 14 through the flow distribution inlet 131. The fluid outlet 1123 of the other of the two cooling plate bodies 11 can be in communication with a liquid outlet flow tube 15 through the flow distribution outlet 132. The fluid outlet 1123 of one of the two cooling plate bodies 11 and the fluid inlet 1112 of the other of the two cooling plate bodies 11 can be located between the fluid inlet 1112 of one of the two cooling plate bodies 11 and the fluid outlet 1123 of the other of the two cooling plate bodies 11, and can be in communication with each other through a connecting flow tube 16. The material of the liquid inlet flow tube 14 and the material of the liquid outlet flow tube 15 can be, for example and without limitation, stainless steel (such as, for example, SUS316L).

In an example embodiment, the water-cooling plate 10 may further comprise two first shielding members 17. The first heat-conducting square tube 111 can have a first opening 1114 on a side away from the fluid inlet 1112. The first opening 1114 can be in communication with the first flow channel 1111. The second heat-conducting square tube 112 can have a second opening 1124 on a side away from the fluid outlet 1123. The second opening 1124 can be in communication with the second flow channel 1121. The first shielding member 17 shields the first opening 1114 and the second opening 1124. The material of the first shielding member 17 can be, for example and without limitation, copper (such as, for example, Cu1100), and the first shielding member 17 can be connected to the first heat-conducting square tube 111 and the second heat-conducting square tube 112, for example, by means of hard soldering.

In an example embodiment, the water-cooling plate 10 may further comprise a second shielding member 18. The second heat-conducting square tube 112 can further have a third opening 1125 on a side away from the second fluid communication port 1122. The third opening 1125 can be in communication with the second flow channel 1121. The second shielding member 18 can shield the third opening 1125. The material of the second shielding member 18 can be, for example and without limitation, copper (such as, for example, Cu1100), and the second shielding member 18 can be connected to the second heat-conducting square tube 112, for example, by means of soldering. In an example implementation, the top plate 113 may further comprise a notch 1131. The notch 1131 can be used to provide space for the third opening 1125 and the second shielding member 18. The first shielding member 17 and the second shielding member 18 may be provided to close the first flow channel 1111 and the second flow channel 1121, so that the first flow channel 1111 and the second flow channel 1121 can be in a closed state.

In an example embodiment, since the water-cooling plate 10 can be provided with a first heat-conducting square tube 111 and a second heat-conducting square tube 112 in the form of a square column, and the first heat-conducting square tube 111 and the second heat-conducting square tube 112 can be connected by means of soldering, compared with water-cooling plates manufactured by means of CNC machining, not only is the manufacturing cost may be lower, but the volume of the first flow channel 1111 and the second flow channel 1121 used for heat exchange may also be increased. In exemplary implementations, the heat dissipation efficiency of the water-cooling plate 10 can be improved.

In further example implementation, when manufacturers want to produce water-cooling plates 10 of different sizes, they may only need to adjust the width and height of the first heat-conducting square tube 111 and the second heat-conducting square tube 112. That is to say, according to example implementation of example embodiments, the structural design of the water-cooling plate 10 can be highly flexible.

In an example embodiment, the number of cooling plate bodies 11, the number of elastic snap-fit members 12, and the number of flow distribution members 13 can be two, and only one connecting flow tube 16 can be provided, but it is not limited thereto. In further example embodiments, only one cooling plate body, only one elastic snap-fit member, and only one flow distribution member may also be provided, and no connecting flow tube may be provided. In other words, according to example implementation of example embodiments, within a single cooling plate body, the fluid inlet can be in communication with the liquid inlet flow tube through the flow distribution inlet, and the fluid outlet can be in communication with the flow distribution outlet through the flow distribution outlet.

According to still further example embodiments, the number of cooling plate bodies, the number of elastic snap-fit members, and the number of flow distribution members may be three or more, and the number of connecting flow tubes may be two or more. In example implementations, the fluid inlet of one of the outermost two cooling plate bodies can be in communication with the liquid inlet flow tube through the flow distribution inlet, the fluid outlet of the other of the outermost two cooling plate bodies can be in communication with the liquid outlet flow tube through the flow distribution outlet, and the remaining fluid outlets can be in communication with the fluid inlets through the connecting flow tubes, respectively.

Referring to Fig. 5, in an example embodiment, when coolant flows from the liquid inlet flow tube 14 into the first heat-conducting square tube 111 of one of the two cooling plate bodies 11, the coolant can first flow along direction A from the flow distribution inlet 131 through the fluid inlet 1112 into the first flow channel 1111. Next, the coolant can flow along direction B within the first flow channel 1111. Then, the coolant can flow from the first heat-conducting square tube 111 into the second heat-conducting square tube 112. According to an example implementation, the coolant can flow along direction C from the first flow channel 1111 through the first fluid communication port 1113 and the second fluid communication port 1122 into the second flow channel 1121.

According to an example implementation, next, the coolant can flow along direction D within the second flow channel 1121. Then, the coolant can flow along direction E within the second flow channel 1121 from the fluid outlet 1123 through the flow distribution outlet 132 into the connecting flow tube 16. Next, the coolant can flow through the connecting flow tube 16 into the other side of the two cooling plate bodies 11. Then, after flowing through the first heat-conducting square tube 111 and the second heat-conducting square tube 112 as described above, the coolant can flow out to the liquid outlet flow tube 15 through the fluid outlet 1123 of the second heat-conducting square tube 112 and the flow distribution outlet 132. At this time, the coolant can absorb heat from the heat source and carry it away, after which the next cooling cycle can begin.

According to the water-cooling plate of the above example embodiments, since the water-cooling plate can be provided with a first heat-conducting square tube and a second heat-conducting square tube in the shape of a square column, and the first heat-conducting square tube and the second heat-conducting square tube are connected by means of soldering, compared with water-cooling plates manufactured by means of CNC machining, not only the manufacturing cost may be lower, but the volume of the first flow channel and the second flow channel used for heat exchange may also be increased. In this way, the heat dissipation efficiency of the water-cooling plate may be improved.

According to example embodiments, when manufacturers want to produce water-cooling plates of different sizes, they may only need to adjust the width and height of the first heat-conducting square tube and the second heat-conducting square tube. That is to say, the structural design of the water-cooling plate of this embodiment may be highly flexible.

The above-presented description and figures are intended by way of example only and are not intended to limit the illustrative embodiments in any way except as set forth in the appended claims. It is particularly noted that various technical aspects of the various elements of the various exemplary embodiments that have been described above can be combined in numerous other ways, all of which are considered to be within the scope of the disclosure.

Accordingly, although exemplary implementations of example embodiment have been disclosed, these are not intended to limit the present disclosure, and any person skilled in the art may make changes and modifications without departing from the spirit and scope of the present disclosure. Therefore, the scope of patent protection of the present disclosure shall be as defined by the scope of the claims appended to this description and equivalents thereof.

The terms and corresponding labels referenced in the disclosure are listed below for convenience. As would be readily appreciated by skilled artisans in the relevant art, while these and other descriptive terms are used throughout this specification to facilitate understanding, it is not intended to limit any components that can be used in combinations or individually to implement various aspects of the embodiments of the present disclosure.
10: Water-cooling plate
11: Cooling plate body
111: First heat-conducting square tube
1111: First flow channel
1112: Fluid inlet
1113: First fluid communication port
1114: First opening
112: Second heat-conducting square tube
1121: Second flow channel
1122: Second fluid communication port
1123: Fluid outlet
1124: Second opening
1125: Third opening
113: Top plate
1131: Notch
114: Bottom plate
12: Elastic snap-fit member
121: Pressing portion
122: Snap-fit portion
13: Flow distribution member
131: Flow distribution inlet
132: Flow distribution outlet
14: Liquid inlet flow tube
15: Liquid outlet flow tube
16: Connecting flow tube
17: First shielding member
18: Second shielding member
A to E: Direction

## Claims

1. A water-cooling plate, comprising:
at least one cooling plate body, comprising:
a first heat-conducting square tube having a first flow channel, a fluid inlet, and a first fluid communication port, wherein the fluid inlet and the first fluid communication port are in communication with the first flow channel; and
a second heat-conducting square tube connected to the first heat-conducting square tube and having a second flow channel, a second fluid communication port and a fluid outlet, wherein the fluid outlet and the second fluid communication port are in communication with the second flow channel, and the first flow channel is in communication with the second flow channel through the first fluid communication port and the second fluid communication port.

2. The water-cooling plate as claimed in claim 1, wherein the at least one cooling plate body further comprises a top plate and a bottom plate, and the first heat-conducting square tube and the second heat-conducting square tube are at least partially sandwiched between the top plate and the bottom plate.

3. The water-cooling plate as claimed in claim 2, further comprising at least one elastic snap-fit member, wherein the at least one elastic snap-fit member is disposed on the top plate to press against the at least one cooling plate body, and is configured to snap onto a plate body provided with a heat source to thermally couple the at least one cooling plate body to the heat source.

4. The water-cooling plate as claimed in claim 3, wherein the at least one elastic snap-fit member comprises a pressing portion and two snap-fit portions, the two snap-fit portions are connected to opposite sides of the pressing portion, the pressing portion presses against the top plate, and the two snap-fit portions are configured to snap onto the plate body.

5. The water-cooling plate as claimed in claim 1, further comprising at least one flow distribution member, a liquid inlet flow tube and a liquid outlet flow tube, wherein the at least one flow distribution member is disposed on one side of the first heat-conducting square tube and the second heat-conducting square tube, the at least one flow distribution member has a flow distribution inlet and a flow distribution outlet, the fluid inlet is in communication with the liquid inlet flow tube through the flow distribution inlet, and the fluid outlet is in communication with the flow distribution outlet through the liquid outlet flow tube.

6. The water-cooling plate as claimed in claim 5, further comprising a plurality of connecting flow tubes, wherein each of the number of at least one cooling plate body and the number of at least one flow distribution member is multiple, the fluid inlet of one of the outermost two cooling plate bodies is in communication with the liquid inlet flow tube through the flow distribution inlet, the fluid outlet of the other of the outermost two cooling plate bodies is in communication with the liquid outlet flow tube through the flow distribution outlet, and the remaining fluid outlets are in communication with the fluid inlets through the connecting flow tubes, respectively.

7. The water-cooling plate as claimed in claim 1, further comprising at least one first shielding member, wherein the first heat-conducting square tube further has a first opening on a side away from the fluid inlet, the first opening is in communication with the first flow channel, the second heat-conducting square tube further has a second opening on a side away from the fluid outlet, the second opening is in communication with the second flow channel, and the at least one first shielding member shields the first opening and the second opening.

8. The water-cooling plate as claimed in claim 7, further comprising a second shielding member, wherein the second heat-conducting square tube further has a third opening on one side away from the second fluid communication port, the third opening is in communication with the second flow channel, and the second shielding member shields the third opening.

9. The water-cooling plate as claimed in claim 1, wherein the first heat-conducting square tube and the second heat-conducting square tube are copper tubes, and the second heat-conducting square tube is soldered to the first heat-conducting square tube.

10. The water-cooling plate as claimed in claim 1, wherein a cross section of the first flow channel parallel to the fluid inlet and a cross section of the second flow channel parallel to the fluid outlet are rectangular.

11. A method of forming a water-cooling plate, the method comprising:
providing at least one cooling plate body comprising
a first heat-conducting square tube having a first flow channel, a fluid inlet, and a first fluid communication port, and
a second heat-conducting square tube connected to the first heat-conducting square tube and having a second flow channel, a second fluid communication port and a fluid outlet;
configuring the fluid inlet and the first fluid communication port in communication with the first flow channel;
configuring the fluid outlet and the second fluid communication port in communication with the second flow channel; and
configuring the first flow channel in communication with the second flow channel through the first fluid communication port and the second fluid communication port.

12. The method as claimed in claim 11, wherein the at least one cooling plate body further comprises a top plate and a bottom plate, the method further comprising
configuring the first heat-conducting square tube and the second heat-conducting square tube are at least partially between the top plate and the bottom plate.

13. The method as claimed in claim 12, further comprising:
disposing at least one elastic snap-fit member on the top plate to press against the at least one cooling plate body; and
configuring the at least one elastic snap-fit member to snap onto a plate body provided with a heat source to thermally couple the at least one cooling plate body to the heat source.

14. The method as claimed in claim 13, wherein the at least one elastic snap-fit member comprises a pressing portion and two snap-fit portions, the two snap-fit portions are connected to opposite sides of the pressing portion, the pressing portion presses against the top plate, and the two snap-fit portions are configured to snap onto the plate body.

15. The method as claimed in claim 11, further comprising:
providing at least one flow distribution member, a liquid inlet flow tube and a liquid outlet flow tube;
disposing the at least one flow distribution member on one side of the first heat-conducting square tube and the second heat-conducting square tube, wherein the at least one flow distribution member comprises a flow distribution inlet and a flow distribution outlet;
configuring the fluid inlet in communication with the liquid inlet flow tube through the flow distribution inlet; and
configuring the fluid outlet in communication with the flow distribution outlet through the liquid outlet flow tube.

16. The method as claimed in claim 5, further comprising:
providing a plurality of connecting flow tubes, wherein each of the number of at least one cooling plate body and the number of at least one flow distribution member is multiple;
configuring the fluid inlet of one of the outermost two cooling plate bodies in communication with the liquid inlet flow tube through the flow distribution inlet;
configuring the fluid outlet of the other of the outermost two cooling plate bodies in communication with the liquid outlet flow tube through the flow distribution outlet; and
configuring the remaining fluid outlets in communication with the fluid inlets through the connecting flow tubes, respectively.

17. The method as claimed in claim 11, further comprising:
providing at least one first shielding member;
providing the first heat-conducting square tube further with a first opening on a side away from the fluid inlet;
configuring the first opening in communication with the first flow channel;
providing the second heat-conducting square tube with a second opening on a side away from the fluid outlet;
configuring the second opening in communication with the second flow channel; and
configuring the at least one first shielding member to shield the first opening and the second opening.

18. The method as claimed in claim 17, further comprising:
providing a second shielding member;
configuring the second heat-conducting square tube with a third opening on one side away from the second fluid communication port;
configuring the third opening in communication with the second flow channel; and
configuring the second shielding member to shield the third opening.

19. The method as claimed in claim 11, wherein the first heat-conducting square tube and the second heat-conducting square tube are copper tubes, the method further comprising
soldering the second heat-conducting square tube to the first heat-conducting square tube.

20. The method as claimed in claim 11, wherein a cross section of the first flow channel parallel to the fluid inlet and a cross section of the second flow channel parallel to the fluid outlet are rectangular.
